# FASCICULE DE BREVET EUROPEEN

(11) **EP 4 016 578 B1**
(45) Date de publication et mention de la délivrance du brevet: **29.01.2025**
(21) Numéro de dépôt: 20306629.5
(22) Date de dépôt: 21.12.2020
(51) Int. Cl.: H01H 71/04, H01H 3/28, H01H 33/38, H01H 47/02, H01H 47/32

(54) **DISPOSITIF DE DIAGNOSTIC D'UNE COMMUTATION, DISPOSITIF DE COMMUTATION ET PROCÉDÉ DE DIAGNOSTIC ASSOCIÉS**
DIAGNOSEVORRICHTUNG FÜR EINE SCHALTUNG, ENTSPRECHENDES SCHALTGERÄT UND DIAGNOSEVERFAHREN
DEVICE FOR DIAGNOSING A SWITCHING EVENT, ASSOCIATED SWITCHING DEVICE AND DIAGNOSTIC METHOD

(43) Date de publication de la demande: 22.06.2022
(73) Titulaire: Schneider Electric Industries SAS, 92500 Rueil-Malmaison (FR)
(72) Inventeur: BERNARD, Jean-Baptiste, 38180 Seyssins (FR); GRAND, Sébastien, 38320 Brié-et-Angonnes (FR)
(74) Mandataire: Lavoix

(56) Documents cités:
- EP-A1- 2 849 195
- US-A1- 2005 103 613

## Description

La présente invention concerne un dispositif de diagnostic d'une commutation. La présente invention concerne également un dispositif de commutation comprenant un tel dispositif de diagnostic et un procédé de diagnostic mis en oeuvre par un tel dispositif de diagnostic.

De nombreuses installations utilisent, pour se protéger des défauts électriques et notamment des surintensités, des dispositifs de commutation (ou « disjoncteurs ») configurés pour couper le courant circulant lorsqu'une intensité de ce courant est trop élevée par rapport à une valeur de référence, par exemple fixée pour éviter un échauffement de conducteurs électriques conduisant le courant.

A cet effet, des disjoncteurs fréquemment utilisés sont du type dit « magnétothermique ». Ces disjoncteurs utilisent un système de commutation pour ouvrir un interrupteur et couper le courant, ce système de commutation agissant par deux biais distincts et indépendants.

Une première partie du système de commutation commande l'ouverture de l'interrupteur lorsqu'un champ magnétique généré par le courant (dont tout ou partie circule par exemple dans une bobine) est supérieur ou égal à un seuil. Par exemple, lorsque le champ magnétique est supérieur ou égal au seuil, la force exercée par ce champ magnétique sur un élément mobile dépasse une autre force, appliquée par exemple par un ressort, et entraîne donc le déplacement de cet élément mobile pour ouvrir l'interrupteur. Ces mécanismes permettent alors une commutation très rapide lorsque l'intensité est très élevée, et notamment en cas de surintensités très ponctuelles et intenses, typiquement en raison d'un court-circuit.

Une deuxième partie commande l'ouverture de l'interrupteur lorsqu'une température du disjoncteur (causée par une surcharge) est supérieure ou égale à un autre seuil. Par exemple, un bilame en contact avec le conducteur dans lequel le courant circule (ou un bilame traversé lui-même par le courant) se déforme, au-delà d'une certaine température, pour entraîner l'ouverture de l'interrupteur. Ces mécanismes sont, par nature, moins rapides que les mécanismes magnétiques, mais permettent un déclenchement à plus basse intensité, pour répondre à des surcharges moins intenses mais de plus longue durée.

Par ailleurs, les systèmes de commutation des disjoncteurs comportent en général une manette pour permettre à un opérateur ou un usager d'ouvrir ou fermer manuellement l'interrupteur.

Ainsi, en cas de coupure du courant par le disjoncteur, plusieurs causes différentes peuvent en être responsable, et ces causes sont de nature très différentes. Il en résulte qu'il est souhaitable de déterminer à l'avance pour quelle raison la coupure a eu lieu avant d'intervenir pour remettre l'installation en marche et fermer l'interrupteur, notamment parce que les précautions à prendre ne sont pas les mêmes selon les cas.

Le document US 2005/103613 A1 décrit un dispositif de diagnostic de la cause d'une coupure provoquée par un disjoncteur magnétothermique.

Toutefois, il est difficile de diagnostiquer à distance les raisons de telles coupures. Par exemple, lorsque les courants sont très élevés, il arrive que les capteurs mesurant l'intensité du courant saturent, et il n'est donc pas possible de déterminer précisément la valeur maximale du courant et notamment s'il a atteint le seuil qui entraîne un déclenchement magnétique du système de commutation. En outre, le fonctionnement du bilame est bien établi dans des conditions optimales et contrôlées, mais peut varier en réalité par rapport à son fonctionnement nominal. Il est alors nécessaire d'établir des tables de correspondances (ou « de déclassement ») pour relier les conditions réelles aux conditions nominales, et ainsi tenir compte des cas spécifiques d'installation.

Il existe donc un besoin pour un dispositif de diagnostic d'une commutation d'un disjoncteur magnétothermique, qui soit plus fiable que les dispositifs de diagnostic de l'état de la technique.

Il est donc proposé un dispositif de diagnostic selon la revendication 1.

Selon des modes de réalisation avantageux mais non obligatoires, le dispositif de diagnostic est selon l'une quelconque des revendications 2 à 10.

Il est également proposé un dispositif de commutation selon la revendication 11.

Selon des modes de réalisation avantageux mais non obligatoires, le dispositif de commutation est selon l'une quelconque des revendications 12 et 13.

Il est également proposé un procédé de diagnostic selon la revendication 14.

Des caractéristiques et avantages de l'invention apparaîtront à la lecture de la description qui va suivre, donnée uniquement à titre d'exemple non limitatif et faite en référence aux dessins annexés, sur lesquels :
- La figure 1 est une représentation schématique d'un dispositif de commutation comportant un dispositif de diagnostic, et
- La figure 2 est un logigramme des étapes d'un procédé de diagnostic mis en oeuvre par le dispositif de diagnostic de la figure 1.

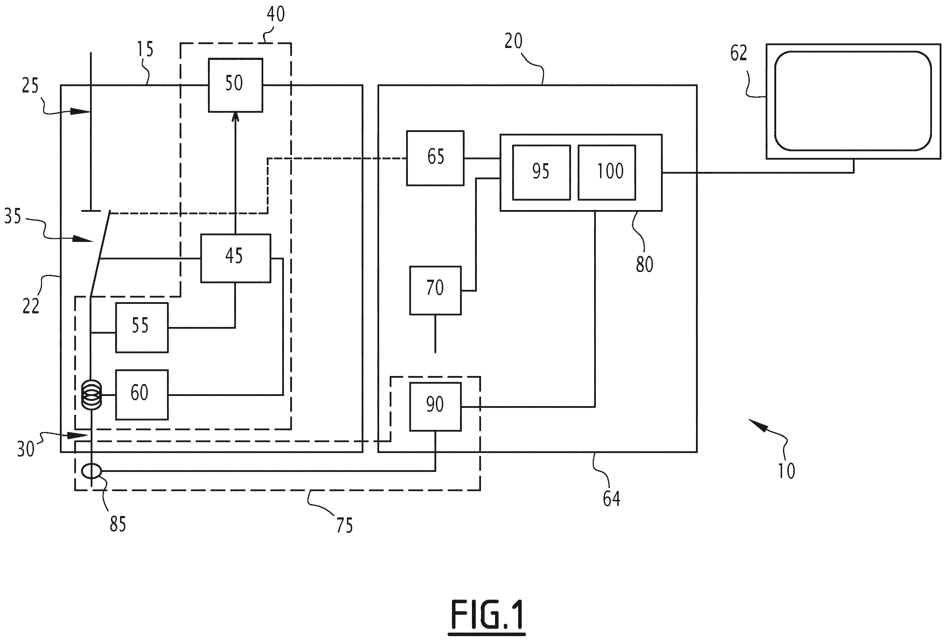

Un dispositif de commutation 10 est représenté sur la figure 1.

Le dispositif de commutation 10 comporte un module de commutation 15 et un dispositif de diagnostic 20.

Le dispositif de commutation 10 sera décrit ci-après dans le cas où le dispositif de commutation 10 comporte un unique pôle, mais il apparaîtra à l'homme du métier que le nombre de pôles (i.e. de paires entrée-sortie que le dispositif de commutation 10 est propre à chacune connecter ou déconnecter) est susceptible de varier.

Le module de commutation 15 et le dispositif de diagnostic 20 sont, par exemple, des appareils distincts l'un de l'autre et formant à eux deux le dispositif de commutation 10. En particulier, le module de commutation 15 et le dispositif de diagnostic 20 sont, comme décrit ci-après, chacun contenus dans un boîtier distinct.

Il est à noter que selon une variante envisageable, le module de commutation 15 et le dispositif de diagnostic 20 sont contenus dans un même boîtier unique, et les éléments composant le module de commutation 15 ne sont, par exemple, pas séparés par une paroi des éléments composant le dispositif de diagnostic 20.

Le module de commutation 15 est connu en soi.

Le module de commutation 15 comporte un premier boîtier 22, au moins une entrée 25, au moins une sortie 30, un organe 35 de commutation et un système 40 de déclenchement.

Le premier boîtier 22 accueille au moins partiellement la ou chaque entrée 25, la ou chaque sortie 30, l'organe de commutation 35 et le système de déclenchement 40.

Le premier boîtier 22 est configuré pour isoler électriquement l'intérieur du premier boîtier 22 de l'extérieur du premier boîtier 22.

Le nombre d'entrée(s) 25 et le nombre de sortie(s) 30 sont chacun égal au nombre de pôle(s) du dispositif de commutation 10, ici égal à un.

L'entrée 25 est électriquement conductrice et configurée pour être connectée à un premier dispositif externe au dispositif de commutation 10. L'entrée 25 est, notamment, configurée pour recevoir un courant électrique de ce dispositif externe.

L'entrée 25 comporte, par exemple, une borne de connexion d'entrée destinée à permettre la connexion d'un conducteur électrique ou d'un connecteur électrique à la borne d'entrée pour relier électriquement le premier dispositif externe à l'entrée 25.

L'entrée 25 comporte un conducteur électrique ou une pluralité de conducteurs électriques connectés entre eux.

L'entrée 25 traverse, par exemple, le premier boîtier 22 pour permettre sa connexion au premier dispositif externe.

En variante, l'entrée 25 est accueillie entièrement dans le premier boîtier 22 mais une partie de l'entrée 25 destinée à être connectée au premier dispositif externe est disposée en face d'une ouverture du premier boîtier 22 de manière à permettre l'introduction d'un conducteur électrique dans le premier boîtier 22.

Le premier dispositif externe peut être de toute nature, par exemple un réseau de distribution électrique.

La sortie 30 est configurée pour recevoir le courant électrique de l'entrée 25 via l'organe de commutation 35. La sortie 30 est, en outre, configurée pour transmettre ce courant à un deuxième dispositif externe au dispositif de commutation 10 auquel la sortie 30 est configurée pour être connectée.

La sortie 30 comporte, par exemple, une borne de connexion de sortie destinée à permettre la connexion d'un conducteur électrique ou d'un connecteur électrique à la borne de sortie pour relier électriquement le deuxième dispositif externe à la sortie 30.

La sortie 30 traverse, par exemple, le premier boîtier 22 pour permettre sa connexion au deuxième dispositif externe. En variante, la sortie 30 est accueillie entièrement dans le premier boîtier 22 mais une partie de la sortie 30 destinée à être connectée au deuxième dispositif externe est disposée en face d'une ouverture du premier boîtier 22 de manière à permettre l'introduction d'un conducteur électrique dans le premier boîtier 22.

Le deuxième dispositif externe peut être de toute nature, par exemple un réseau électrique domestique, ou encore un appareil consommateur d'énergie électrique.

L'organe de commutation 35 est, de manière connue en soi, configuré pour commuter entre une première position et une deuxième position.

Lorsque l'organe de commutation 35 est dans la première position, l'organe de commutation 35 relie électriquement l'entrée 25 et la sortie 30.

Lorsque l'organe de commutation 35 est dans la deuxième position, l'organe de commutation 35 isole électriquement l'entrée 25 et la sortie 30.

L'organe de commutation 35 comporte notamment, de manière connue en soi, un conducteur électrique mobile entre une position dans laquelle le conducteur électrique est connecté simultanément à l'entrée 25 et à la sortie 30, et une position dans laquelle le conducteur électrique est déconnecté de l'une au moins parmi l'entrée 25 et la sortie 30.

L'organe de commutation 35 comporte, également, un mécanisme de déplacement du conducteur mobile entre ses deux positions.

Le système de déclenchement 40 est configuré, de manière connue en soi, pour commander une commutation de l'organe de commutation 35 depuis la première position jusqu'à la deuxième position, et vice-versa.

En particulier, le système de déclenchement 40 comporte un mécanisme 45 de déclenchement, un organe 50 de commande manuelle, un premier sous-système 55 de déclenchement thermique et un deuxième sous-système 60 de déclenchement magnétique.

De par la présence des deux sous-systèmes 55 et 60, le module de commutation 15 est souvent qualifié de « disjoncteur magnétothermique » (ou « Thermal-magnetic Circuit Breaker », en Anglais), notamment lorsqu'il forme un dispositif séparé du dispositif de diagnostic 20. Dans le cas où ces deux éléments 15 et 20 forment un même dispositif contenu dans un même boîtier, c'est alors le dispositif de commutation 10 qui est appelé « disjoncteur magnétothermique », dans son ensemble.

Le mécanisme de déclenchement 45 est configuré pour agir sur l'organe de commutation pour faire commuter l'organe de commutation 35 entre ses deux positions.

L'organe de commande manuelle 50 est configuré pour être actionné par un opérateur de manière à commander la commutation, par le mécanisme de déclenchement 45, de l'organe de commutation 35 depuis la première position jusqu'à la deuxième position, ou vice-versa.

L'organe de commande manuelle 50 comporte, par exemple, une manette actionnable en rotation autour d'un axe entre deux positions correspondant chacune à une position de l'organe de commutation 35.

En variante, l'organe de commande manuelle 50 comprend au moins un bouton configuré pour entraîner une commutation de l'organe de commutation 35 de l'une de ses positions à l'autre lorsque l'opérateur appuie sur le bouton. Selon un mode de réalisation, l'organe de commande manuelle 50 comporte deux boutons, l'un entraînant une commutation de la première à la deuxième position et l'autre de la deuxième à la première position suite à une pression de l'opérateur.

Il est à noter que de nombreux types d'organes de commande manuelle 50 différents peuvent être envisagés.

Le premier sous-système 55 est configuré pour commander une commutation de l'organe de commutation 35 depuis la première position jusqu'à la deuxième position lorsqu'un premier critère est vérifié.

Le premier critère est le fait qu'une première température du module de commutation 15 est supérieure ou égale à un seuil de température.

Par exemple, le premier sous-système 55 comporte, de manière connue en soi, un bilame qui fait par exemple partie d'un circuit électrique reliant l'organe de commutation 35 à la sortie 30 et qui est configuré pour être traversé par le courant circulant depuis l'entrée 25 à la sortie 30 lorsque l'organe de commutation 35 est dans la première position (ou qui est en contact avec un conducteur traversé par ce courant). Le bilame est configuré pour se déformer en fonction de sa température et pour agir sur le mécanisme de déclenchement 45 de manière à faire commuter l'organe de commutation 35 vers sa deuxième position lorsque la température du bilame est supérieure ou égale au seuil de température. La première température est alors la température du bilame.

Le seuil de température est choisi, de manière connue en soi, comme étant telle que, lors d'un fonctionnement normal du dispositif de commutation 10 dans des conditions nominales, l'effet Joule provoque l'augmentation de la première température jusqu'au seuil de température lorsque l'intensité du courant est égale ou supérieure à un premier seuil de courant pendant une durée prédéterminée.

La durée prédéterminée dépend par exemple des conditions de fonctionnement et du réglage du bilame.

Le premier seuil de courant est, par exemple, compris entre 1,05 et 1,3 fois un courant maximal acceptable sans déclenchement, à une température de référence, (ou « calibre ») du dispositif 10, selon la norme IEC60898-1. Toutefois, ce premier seuil est susceptible de varier.

Il est à noter que d'autres types de premiers sous-système commandant une commutation lorsqu'une première température atteint un seuil de température sont également envisageables, notamment des systèmes ne comportant pas de bilame.

Le deuxième sous-système 60 est configuré pour commander une commutation de l'organe de commutation 35 depuis la première position jusqu'à la deuxième position lorsqu'un deuxième critère est vérifié.

Le deuxième critère est le fait qu'un champ magnétique généré par le courant circulant entre l'entrée 25 et la sortie 30 est supérieur ou égal à un seuil de champ.

Par exemple, le module de commutation 15 comporte une bobine dans laquelle le courant (ou une partie du courant si cette bobine est connectée en parallèle avec un autre conducteur électrique) circule. Le champ magnétique généré par la bobine agit sur un élément mobile du deuxième sous-système 60. Lorsque le champ magnétique est supérieur ou égal au seuil de champ, la force exercée sur l'élément mobile par le champ magnétique entraîne le déplacement de celui-ci, et ce déplacement agit sur le mécanisme de déclenchement 45 pour commander la commutation de l'organe de commutation 35 vers sa deuxième position.

Le seuil de champ est choisi tel que le courant génère un champ magnétique égal au seuil de champ lorsque le courant présente une valeur d'intensité égale à un deuxième seuil de courant.

Le deuxième seuil de courant est notamment strictement supérieur au premier seuil de courant. Le deuxième seuil de courant est, par exemple, compris entre 3 fois et 10 fois le calibre. Ainsi, le système de déclenchement 40 commande la commutation de l'organe de commutation 35 vers sa deuxième position lorsque l'un quelconque des premier et deuxième critères est vérifié, ou lorsque les deux critères sont vérifiés.

Le dispositif de diagnostic 20 est configuré pour détecter une commutation de l'organe de commutation 35, pour effectuer un diagnostic de la commutation et pour transmettre des données de diagnostic à un dispositif 62 externe au dispositif de commutation 10.

Le dispositif 62 est, par exemple, un ordinateur ou un serveur pourvu d'une interface homme-machine et propre à transmettre les données reçues à un opérateur, par exemple en affichant les données sur un écran de l'interface homme-machine.

Il est entendu par « effectuer un diagnostic de la commutation » que le dispositif de diagnostic 20 assigne la commutation détectée à une cause parmi :
- un déclenchement causé par le premier sous-système 55 en raison du premier critère, i.e. parce que le premier critère est vérifié ou a été vérifié ;
- un déclenchement causé par le deuxième sous-système 60 en raison du deuxième critère, i.e. parce que le deuxième critère est vérifié ou a été vérifié ; et
- un déclenchement manuel, causé par une activation de l'organe de commande manuelle 50 par un opérateur.

Les données de diagnostic comportent, par exemple, un identifiant de la cause de la commutation, par exemple « 1 », « 2 » ou « 3 », ou toute indication permettant au dispositif 62 d'identifier, parmi les trois causes possibles, la cause de la commutation détectée.

Les données de diagnostic comportent, optionnellement, des informations additionnelles telles que : un instant temporel de la commutation, des valeurs de tension ou de courant mesurées à l'instant où la commutation a été commandée par le système de déclenchement 40. Le dispositif de diagnostic 20 comporte un deuxième boîtier 64, un capteur 65 de commutation, un capteur 70 de température, un capteur 75 de courant et un contrôleur 80.

Le deuxième boîtier 64 accueille au moins partiellement le capteur 65 de commutation, le capteur 70 de température, le capteur 75 de courant et le contrôleur 80.

Le deuxième boîtier 64 est, par exemple, configuré pour maintenir en position le capteur 65 de commutation, le capteur 70 de température, le capteur 75 de courant et le contrôleur 80 les uns par rapport aux autres.

Le deuxième boîtier 64 est, par exemple, fixé au premier boîtier 22 par un ou plusieurs crochet(s), et éventuellement par un ou plusieurs conducteurs électriques. En variante, le deuxième boîtier 64 et le premier boîtier 22 sont tous les deux fixés à un même support propre à les maintenir en position l'un par rapport à l'autre.

Il est à noter que des modes de réalisation du dispositif de diagnostic 20 sans boîtier 64 sont également envisageables. Dans ce cas, le capteur 65 de commutation, le capteur 70 de température, le capteur 75 de courant et le contrôleur 80 sont accueillis dans le boîtier 22, par exemple.

Le capteur de commutation 65 est configuré pour mesurer une information relative à une commutation de l'organe de commutation 35 et pour signaler au contrôleur 80 qu'une commutation de l'organe de commutation 35 a eu lieu.

Le capteur de commutation 65 est, par exemple, mécaniquement relié à l'organe de commutation 35 et partiellement mobile avec lui de sorte actionner un module générant un signal électrique fonction de la position de l'organe de commutation 35.

En variante, le capteur de commutation 65 est configuré pour estimer dans quelle position est l'organe de commutation 35 en évaluant si un courant circule ou non entre l'entrée 25 et la sortie 30.

En variante, le capteur de commutation 65 détecte par un contact électrique la position de l'organe de commande manuelle 50, qui est lui-même solidaire de la position de l'organe de commutation 35.

De manière générale, de nombreux types de capteur de commutation 65 sont susceptibles d'être utilisés.

Le capteur de température 70 est configuré pour mesurer des valeurs d'une deuxième température du dispositif de commutation 10, par exemple à l'aide d'un thermocouple.

La deuxième température est, par exemple, mesurée à l'intérieur du deuxième boîtier 64. Dans ce cas, la deuxième température est une température du dispositif de diagnostic 20.

En variante, la deuxième température est une température du module de commutation 15, par exemple d'un conducteur électrique du module de commutation 15, notamment une température de l'entrée 25 ou de la sortie 30. Dans ce cas, le capteur de température 70 vient en contact avec au moins une partie du module de commutation 15, notamment de ce conducteur électrique, en traversant au moins le deuxième boîtier 64 et optionnellement à travers le premier boîtier 22.

La deuxième température est, notamment, une température dont la variation est corrélée à la variation de la première température. Le capteur de température 70 est, pour cela, fréquemment positionné à proximité immédiate du bilame, par exemple à un centimètre de distance ou moins.

Le capteur de courant 75 est configuré pour mesurer des valeurs d'une intensité du courant traversant le module de commutation 15 depuis l'entrée 25 jusqu'à la sortie 30.

Par exemple, le capteur de courant 75 est configuré pour mesurer des valeurs de l'intensité de manière périodique au cours du temps. La fréquence des mesures est, par exemple, supérieure ou égale à 1 kilohertz(kHz), par exemple égale à 20 kHz.

Le capteur de courant 75 comporte, par exemple, un capteur 85 configuré pour mesurer des valeurs de l'intensité sous forme analogique et un convertisseur analogique/numérique 90 configuré pour convertir les valeurs mesurées sous forme d'un signal numérique et pour transmettre le signal numérique au contrôleur 80. Il est à noter que le contrôleur 80 et le convertisseur analogique/numérique 90 sont parfois un seul et même élément réalisant ces deux fonctions.

Optionnellement, le capteur de courant 75 réalise un filtrage fréquentiel des valeurs mesurées, par exemple un filtrage passe-bande autour de la fréquence attendue du courant, avant de transmettre les valeurs mesurées au contrôleur 80.

Il est défini une valeur de saturation pour le capteur de courant 75.

La valeur de saturation est une valeur maximale d'intensité, en valeur absolue, que le capteur de courant 75 est propre à mesurer. Par exemple, lorsque le courant présente une valeur d'intensité supérieure ou égale, en valeur absolue, à la valeur de saturation, le capteur de courant 75 génère un signal indiquant que l'intensité du courant est égale, en valeur absolue, à la valeur de saturation.

En d'autres termes, la valeur de saturation est telle que le capteur de courant 75 ne peut différencier, en valeur absolue, deux courants présentant des intensités supérieures en valeur absolue à la valeur de saturation.

Le capteur 85 comporte, par exemple, un tore conducteur entourant un conducteur du module de commutation 15 (par exemple entourant un conducteur formant une portion de l'entrée 25 ou de la sortie 30) et configuré pour générer un courant électrique en fonction d'un champ magnétique généré par le courant circulant dans ledit conducteur. La mesure de l'intensité du courant électrique généré par le tore permet alors d'estimer la valeur du champ magnétique et donc l'intensité du courant circulant dans le conducteur.

Il est à noter que de nombreux types de capteurs de courant 75 sont susceptibles d'être utilisés, par exemples des capteurs shunt ou des transformateurs de courant, connus en eux-mêmes de l'homme du métier.

Le contrôleur 80 est configuré pour détecter une commutation de l'organe de commutation 35 à partir d'au moins une information transmise par le capteur de commutation 65.

Le contrôleur 80 est, en outre, configuré pour recevoir les valeurs d'intensité et de deuxième température mesurées et pour diagnostiquer une commutation détectée à partir des valeurs d'intensité et de deuxième température reçues.

Le contrôleur 80 comporte, par exemple, un processeur 95 et une mémoire 100.

La mémoire 100 contient des instructions logicielles configurées pour mettre en oeuvre un procédé de diagnostic d'une commutation du dispositif de commutation 10 lorsqu'elles sont exécutées sur le processeur 95.

Le contrôleur 80 est configuré pour communiquer avec le dispositif externe 62, par exemple par une liaison de données sans fil ou encore par un réseau filaire.

En variante, le contrôleur 80 est formé par un circuit intégré dédié (en Anglais, « Application-Specific Integrated Circuit »), par un ensemble de composants logiques programmables, ou encore par tout ensemble de composants électroniques.

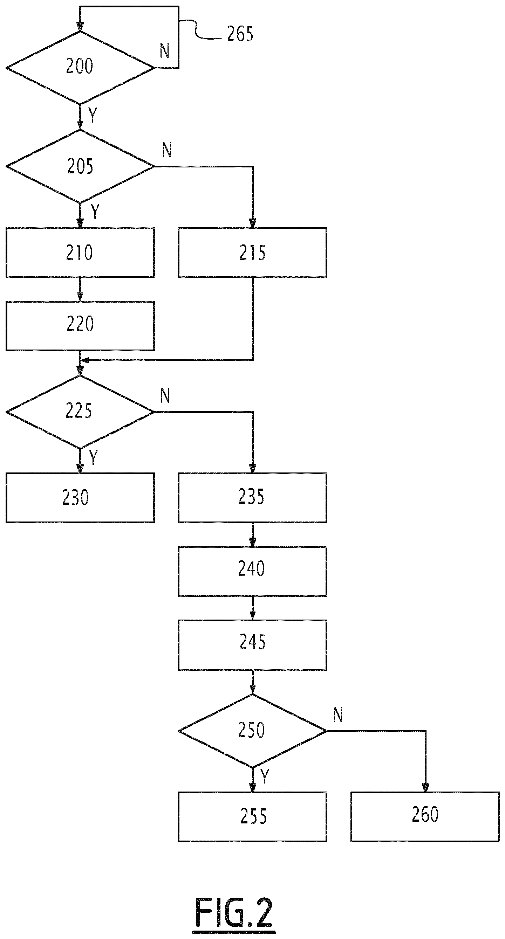

Le fonctionnement du dispositif de diagnostic 20 va maintenant être décrit en regard de la figure 2, que représente un logigramme des étapes du procédé de diagnostic mis en oeuvre par ce dispositif 20.

Le procédé de diagnostic comporte une étape 200 initiale, une étape 205 de détection, une première étape 210 de calcul, une première étape 215 d'estimation, une deuxième étape 220 d'estimation, une première étape 225 de comparaison, une première étape 230 de diagnostic, une deuxième étape 235 de calcul, une étape 240 de détermination, une troisième étape 245 de calcul, une deuxième étape 250 de comparaison, une deuxième étape 255 de diagnostic et une troisième étape 260 de diagnostic.

Au début de l'étape initiale 200, l'organe de commutation 35 est dans la première position, et un courant circule à travers l'organe de commutation 35 depuis l'entrée 25 jusqu'à la sortie 30.

Le courant est, par exemple, un courant alternatif présentant une période nominale. La période nominale est, par exemple, égale à 50 Hertz (Hz), mais est susceptible de varier d'une installation à l'autre.

Lors de l'étape initiale 200, au moins une valeur de deuxième température est mesurée par le capteur de température 70 et transmise au contrôleur 80, notamment au deuxième module de diagnostic 110.

Par exemple, des valeurs de la deuxième température sont mesurées périodiquement par le capteur de température 70, avec une période temporelle comprise par exemple entre 100 millisecondes (ms) et 10 secondes, bien que ces valeurs soient susceptibles de varier, notamment en fonction de la capacité thermique du bilame. En outre, le capteur de courant 75 mesure au moins une valeur de l'intensité du courant circulant entre l'entrée 25 et la sortie 30. Par exemple, des valeurs d'intensité sont mesurées par le capteur de courant 75 de manière périodique. En variante, les valeurs d'intensité sont mesurées en continu par le capteur de courant 75, par exemple sur une fenêtre temporelle glissante.

L'étape initiale 200 est mise en oeuvre jusqu'à ce qu'une commutation de la première position à la deuxième position de l'organe de commutation 35 ait lieu. Cela est représenté par une flèche 265 sur la figure 2.

Il est supposé qu'une commutation a lieu au cours de l'étape initiale 200.

La commutation entraîne l'émission, par le capteur de commutation 65, d'au moins un signal indiquant au contrôleur 80 qu'une commutation a eu lieu.

Le contrôleur 80 détecte la commutation suite à la réception du signal émis par le capteur de commutation 65.

Le contrôleur 80 met en oeuvre l'étape de détection 205 suite à la détection de la commutation.

Au cours de l'étape de détection 205, le contrôleur 80 détecte si une saturation du capteur de courant 75 a eu lieu au cours d'une première plage temporelle précédant immédiatement la commutation.

Par exemple, la première plage temporelle présente une durée temporelle prédéterminée et se termine à l'instant de la commutation.

Selon un mode de réalisation, la première plage temporelle est définie comme étant la plage temporelle au cours de laquelle un nombre prédéterminé de valeurs d'intensité sont mesurées, la plus récente des valeurs mesurées au cours de cette première plage étant la dernière valeur non nulle mesurée (puisque la commutation coupe le courant).

La première plage temporelle est, par exemple, une plage temporelle présentant une durée égale à une demi-période nominale du courant et se terminant à l'instant de la commutation. En variante, la première plage temporelle présente une durée égale à une pluralité de demi-périodes nominales, par exemple à 5 demi-périodes.

La saturation est, par exemple, détectée si le capteur de courant 75 transmet au contrôleur 80 une pluralité de valeurs d'intensité successives présentant des valeurs égales les unes aux autres et égales, en valeur absolue, à la valeur de saturation. En variante, la valeur de saturation est une valeur estimée légèrement inférieure au seuil réel de saturation, et la saturation est, alors, détectée si le capteur de courant 75 transmet au contrôleur 80 une pluralité de valeurs d'intensité successives présentant des valeurs supérieures ou égales, en valeur absolue, à la valeur de saturation.

Si une saturation est détectée, la première étape de calcul 210 est mise en oeuvre. Dans le cas contraire la première étape d'estimation 215 est mise en oeuvre.

Au cours de la première étape de calcul 210, le contrôleur 80 calcule au moins une valeur d'une dérivée temporelle de l'intensité mesurée.

Par exemple, le contrôleur 80 calcule une valeur d'une dérivée temporelle de l'intensité à un instant auquel l'intensité est égale à zéro au cours de la première plage temporelle, notamment à un instant auquel l'intensité est égale à zéro et la valeur d'intensité augmente au cours du temps.

En variante, le contrôleur 80 calcule une valeur de la dérivée temporelle de l'intensité correspondant à chaque instant auquel une valeur d'intensité a été mesurée pendant la première plage temporelle.

La première étape de calcul 210 est suivie de la deuxième étape d'estimation 220.

Lors de la deuxième étape d'estimation 220, une valeur d'intensité est estimée par le contrôleur 80. La valeur estimée est, notamment, une valeur maximale de l'intensité du courant au cours de la première plage temporelle.

La valeur d'intensité estimée est estimée à partir d'au moins une valeur de dérivée temporelle calculée, notamment à partir de la valeur de dérivée temporelle à l'instant auquel l'intensité est égale à zéro.

En variante, la valeur d'intensité estimée est estimée à partir de la valeur de dérivée maximale (en valeur absolue) parmi les valeurs de dérivée calculées.

La valeur d'intensité estimée est, par exemple, estimée en considérant que l'intensité du courant est une fonction sinusoïdale du temps, et en calculant la valeur d'intensité estimée à partir de la connaissance de la valeur de la dérivée à l'instant où l'intensité est égale à zéro.

La valeur de dérivée maximale est par exemple considérée comme étant la valeur de la dérivée à un instant où l'intensité est égale à zéro et augmente au cours du temps, puisque ces affirmations sont vraies lorsque le courant est une fonction sinusoïdale du temps.

La deuxième étape d'estimation 220 est suivie de la première étape de comparaison 225.

Au cours de la première étape d'estimation 215, une valeur maximale de l'intensité est estimée par le contrôleur.

La valeur maximale de l'intensité est, par exemple, la valeur la plus élevée parmi les valeurs d'intensité mesurées au cours de la première plage temporelle. En variante, la valeur maximale de l'intensité est estimée par interpolation ou extrapolation à partir des valeurs d'intensité mesurées, en considérant que le courant est une fonction sinusoïdale du temps.

La première étape d'estimation 215 est suivie de la première étape de comparaison 225.

Lors de la première étape de comparaison 225, la valeur d'intensité estimée au cours de l'étape 215 ou 220 est comparée au deuxième seuil de courant.

Si la valeur d'intensité estimée est supérieure ou égale au deuxième seuil de courant, la première étape de diagnostic 230 est mise en oeuvre. Dans le cas contraire, le contrôleur 80 détermine que la commutation n'a pas été causée parce que le deuxième critère a été vérifié, et la deuxième étape de calcul 235 est mise en oeuvre.

Au cours de la première étape de diagnostic 230, le contrôleur 80 diagnostique la commutation comme étant une commutation causée en raison du deuxième critère. En d'autres termes, le contrôleur 80 arrive à la conclusion que la commutation a été causée par le deuxième sous-système de déclenchement 60 parce que le champ magnétique généré par le courant était supérieur ou égal au seuil de champ.

Lors de la première étape de diagnostic 230, le contrôleur 80 génère et transmet au dispositif distant 62 un message de diagnostic indiquant que la commutation a été causée par le deuxième sous-système 60.

En variante, le dispositif de diagnostic 20 génère un signal à destination d'un opérateur indiquant la cause de la commutation, par exemple en affichant un message sur un écran du dispositif de diagnostic 20, ou encore en faisant apparaître un indicateur tel qu'un élément mobile coloré visible depuis l'extérieur du dispositif de diagnostic 20 et indiquant la cause de la commutation.

Lors de la deuxième étape de calcul 235, le contrôleur 80 calcule une valeur moyenne de la deuxième température.

La valeur moyenne est, par exemple, une moyenne arithmétique de valeurs de deuxième température, c'est-à-dire une moyenne calculée en sommant une pluralité de valeurs de deuxième températures acquises et en divisant la somme par le nombre de valeurs sommées.

La valeur moyenne est, par exemple, calculée à partir de valeurs de deuxième températures acquises successivement pendant une deuxième plage temporelle.

La deuxième plage temporelle présente, par exemple, une durée temporelle prédéterminée et est définie comme étant la première plage temporelle présentant cette durée et se terminant à l'instant de la commutation.

Selon un mode de réalisation, la deuxième plage temporelle est définie comme étant la plage temporelle au cours de laquelle un nombre prédéterminé de valeurs d'intensité sont mesurées, la plus récente des valeurs mesurées au cours de cette deuxième plage étant la dernière valeur non nulle mesurée (puisque la commutation coupe le courant).

La deuxième plage temporelle présente, par exemple, une durée comprise entre 0 et 1 seconde.

La deuxième étape de calcul 235 est suivie de l'étape de détermination 240.

Lors de l'étape de détermination 240, le contrôleur 80 détermine un troisième seuil de courant en fonction de la valeur moyenne de deuxième température calculée.

Il est à noter qu'en variante, le troisième seuil est déterminé en fonction d'une unique valeur de deuxième température, mesurée par exemple à l'instant de la commutation.

Le troisième seuil de courant est tel que l'effet Joule provoque l'augmentation de la première température jusqu'au seuil de température lorsque l'intensité du courant est égale ou supérieure au troisième seuil de courant pendant une durée prédéterminée et lorsque la deuxième température est égale à la valeur moyenne de deuxième température calculée.

En d'autres termes, le troisième seuil de courant est calculé pour prendre en compte que, dans les conditions réelles de fonctionnement du module de commutation 15, le module de commutation 15 est susceptible d'être réchauffé ou refroidi par des facteurs extérieurs et qu'ainsi, la relation entre l'intensité du courant et la première température est susceptible d'être différente de ce qui a été considéré pour fixer le seuil de température.

Par exemple, si le seuil de température a été fixé tel que le premier sous-système 55 déclenche une commutation de l'organe de commutation 35 lorsque l'intensité du courant est égale au premier seuil pendant une durée prédéterminée et que le module de commutation 15 est placé seul au milieu d'un volume d'air à 15 °C de 3 mètres cube (ces valeurs étant des exemples susceptibles de varier), la commutation aura lieu pour une intensité plus basse si le module de commutation 15 est chauffé au-delà de 15°C, par exemple par des appareils voisins ou pendant l'été. Inversement, pendant l'hiver ou en cas de courant d'air important, le déclenchement aura lieu à une intensité plus élevée.

Le troisième seuil de courant est, par exemple déterminé à partir de la valeur moyenne de deuxième température et d'une table, mémorisée dans la mémoire 100 et contenant, pour une pluralité de valeurs mémorisées de deuxième température, des valeurs respectives de troisième seuil.

En variante, la table contient, pour chaque valeur de deuxième température mémorisée dans la table, un coefficient tel que le troisième seuil est déterminé en multipliant le premier seuil par le coefficient.

Chaque valeur de coefficient est strictement supérieure à zéro.

Par exemple, pour une valeur de deuxième température mémorisée supérieure strictement à la valeur de deuxième température attendue lorsque le dispositif de commutation 10 est placé seul au milieu d'un volume d'air à 15 °C de 3 mètres cube, la valeur de coefficient correspondante est strictement inférieure à un. Pour une valeur de deuxième température mémorisée inférieure strictement à la valeur de deuxième température attendue lorsque le dispositif de commutation 10 est placé seul au milieu d'un volume d'air à 15 °C de 3 mètres cube, la valeur de coefficient correspondante est strictement supérieure à un.

Lorsque la valeur moyenne de deuxième température est comprise strictement entre deux valeurs successives de deuxième température mémorisées dans la table, le troisième seuil est, par exemple, calculé soit par interpolation à partir des deux valeurs de troisième seuil correspondant auxdites deux valeurs successives de deuxième température mémorisées, soit par interpolation à partir des deux valeurs de coefficient correspondant à ces valeurs successives.

En variante, si la valeur moyenne de deuxième température est comprise strictement entre deux valeurs successives de deuxième température mémorisées dans la table, le troisième seuil déterminé est le troisième seuil correspondant à la valeur de deuxième température mémorisée la plus proche de la valeur moyenne.

La table est, par exemple, une table déterminée expérimentalement en mesurant une valeur d'intensité à laquelle le premier sous-système 55 déclenche la commutation pour chaque valeur de deuxième température mémorisée.

Une différence entre des valeurs successives de deuxième température mémorisées dans la table est, par exemple, comprise entre 1 degré Celsius (°C) et 10 °C, par exemple égale à 5 °C.

En variante, le troisième seuil est calculé à partir d'une fonction, mémorisée dans la mémoire 100, et par exemple déterminée expérimentalement, reliant la valeur du troisième seuil à la deuxième température mesurée. La fonction est, par exemple, une fonction affine définie par deux coefficients stockés dans la mémoire 100.

Il est à noter que selon une variante envisageable, le troisième seuil est calculé à partir d'une unique valeur de deuxième température mesurée et non d'une valeur moyenne.

De manière général, il est à noter que le troisième seuil est susceptible d'être calculé ou déterminé de différentes manières en fonction d'une ou plusieurs valeurs de deuxième température.

La troisième étape de calcul 245 est mise en oeuvre immédiatement après l'étape de détermination 240.

Au cours de la troisième étape de calcul 245, une valeur moyenne d'intensité est calculée.

La valeur moyenne de l'intensité est, par exemple, calculée sur la deuxième plage temporelle.

La valeur moyenne d'intensité est, par exemple, calculée à partir d'une pluralité de valeurs RMS (de l'Anglais « Root Means Square ») successives, par exemple par une moyenne arithmétique des valeurs RMS.

Le nombre de valeurs RMS successives entrant dans le calcul de la valeur moyenne d'intensité est, par exemple, compris entre 0 et 10, par exemple égale à 5.

Selon un mode de réalisation, le contrôleur 80 calcule périodiquement, lors de l'étape initiale 200, des valeurs RMS à partir, par exemple, de N valeurs d'intensité mesurées successivement par le capteur de courant 75 (N étant un entier strictement supérieur à 1).

Une valeur RMS est calculée, de manière connue en soi, en calculant la racine carrée de la moyenne des carrés des valeurs mesurées, par exemple la racine carrée d'un rapport entre, au numérateur, une somme de carrés des N valeurs d'intensités et, au dénominateur, le nombre N.

Le nombre N est, par exemple, égal au nombre d'échantillons d'intensité acquises pendant une période nominale du courant. Dans ce cas, le nombre N est, notamment, compris entre 303 et 444 lorsque la fréquence nominale du courant est entre 45 Hz et 66 Hz et l'échantillonnage effectué à 20 kHz.

La troisième étape de calcul 245 est suivie de la deuxième étape 250 de comparaison.

Lors de la deuxième étape de comparaison, le contrôleur 80 compare la valeur moyenne d'intensité calculée au troisième seuil.

Si la valeur moyenne d'intensité est supérieure ou égale au troisième seuil, la deuxième étape de diagnostic 255 est mise en oeuvre. Sinon, la troisième étape de diagnostic 260 est mise en oeuvre.

Au cours de la deuxième étape de diagnostic 255, le contrôleur 80 diagnostique la commutation comme étant une commutation causée en raison du premier critère. En d'autres termes, le contrôleur 80 arrive à la conclusion que la commutation a été causée par le premier sous-système de déclenchement 55 parce que la première température était supérieure ou égale au seuil de température.

Lors de la deuxième étape de diagnostic 255, le contrôleur 80 génère et transmet au dispositif distant 62 un message de diagnostic indiquant que la commutation a été causée par le premier sous-système 55.

Au cours de la troisième étape de diagnostic 260, le contrôleur 80 diagnostique la commutation comme étant une commutation causée par une activation de l'organe de commande manuelle 50 par un opérateur.

Lors de la troisième étape de diagnostic 260, le contrôleur 80 génère et transmet au dispositif distant 62 un message de diagnostic indiquant que la commutation a été causée par l'organe de commande manuelle 50.

Grâce à l'invention, le dispositif de diagnostic 20 différencie efficacement des déclenchements causés par les sous-systèmes 55 et 60 ou par l'organe de commande manuelle 50, même lorsque le dispositif de commutation 10 est placé dans un environnement susceptible de le chauffer ou de le refroidir par rapport aux conditions nominales pour lesquelles le seuil de température a été choisi.

Il est notamment évité que le dispositif de diagnostic 20 attribue un déclenchement à une cause erronée parce que la température du dispositif de commutation 10 est élevée ou au contraire basse par rapport aux conditions nominales. En effet, la prise en compte de la deuxième température permet de prendre en compte le fait que le dispositif de diagnostic 10 est placé dans des conditions de température différentes de celles pour lesquelles le premier sous-système de déclenchement 60 a été calibré initialement.

L'information transmise à un opérateur devant intervenir sur l'installation comportant le dispositif de commutation 10 est donc plus précise, ce qui permet de rendre l'intervention plus pertinente, plus rapide, et surtout plus sécurisée (puisque certaines actions, pertinentes pour une cause de déclenchement, peuvent s'avérer dangereuses pour d'autres causes).

Le fait de calculer le troisième seuil en fonction d'une ou plusieurs valeurs de deuxième température mesurées permet de prendre en compte de manière précise l'influence de la température du dispositif de diagnostic 10 sur le fonctionnement du sous-système 55.

L'utilisation d'une table contenant des valeurs du troisième seuil en fonction de valeurs de deuxième température mesurées permet de calculer le troisième seuil de manière simple et rapide sans capacité de calcul élevée.

L'utilisation d'une valeur moyenne de la deuxième température reflète précisément l'influence de la deuxième température sur le fonctionnement du sous-système 55.

Lorsque la valeur maximale d'intensité est calculée à partir d'une dérivée des valeurs d'intensité mesurées, la valeur maximale peut être calculée précisément même lorsqu'elle dépasse la valeur de saturation du capteur de courant 75.

Toutefois, en l'absence de saturation, le fait de considérer la valeur maximale comme étant directement la valeur la plus élevée parmi les valeurs mesurées permet un traitement plus rapide et est plus précis que l'utilisation de la dérivée.

L'utilisation de la valeur maximale de la dérivée dans le calcul de la valeur maximale de l'intensité permet une plus grande précision que l'utilisation d'autres valeurs de la dérivée.

Le fait de comparer la valeur maximale de l'intensité au deuxième seuil de courant permet de détecter une commutation selon le deuxième critère de manière simple et rapide.

Une commutation causée par l'organe de commande manuelle 50 est aisément et simplement détectée lorsqu'il est déterminé que les premier et deuxième critères ne s'appliquent pas, plutôt que de prévoir un traitement spécifique tel qu'une détection de l'actionnement de l'organe 50 à l'aide d'un capteur spécifique. Le dispositif de commutation 10 est notamment simplifié puisque ce capteur spécifique n'est pas requis.

Lorsque la deuxième température est une température du dispositif de diagnostic 20, le dispositif de diagnostic 20 est particulièrement aisé à fabriquer puisqu'il n'est pas nécessaire de prévoir un accès au module de commutation 15 (par exemple) pour le capteur 70 de température. En outre, le capteur de température 70 est susceptible d'être disposé à l'intérieur d'un éventuel boîtier 64 et donc d'être protégé, notamment lorsque le dispositif 20 et le module 15 sont deux appareils séparés munis de boîtiers distincts.

Lorsque la deuxième température est une température du module de commutation 15, le diagnostic est plus précis, puisque cette deuxième température reflète plus précisément la première température. Des diagnostics erronés lorsque, par exemple, le module de commutation 15 n'est pas chauffé ou refroidi de manière similaire au dispositif de diagnostic 10 sont alors évités.

Il est à noter que, selon une variante envisageable, qui ne fait pas partie de l'invention, une commutation causée par le premier critère est susceptible d'être diagnostiquée en comparant directement une valeur de deuxième température, par exemple la valeur moyenne de deuxième température, à un seuil de température correspondant. Par exemple, si la deuxième température est la première température (notamment si le capteur de température 70 vient mesurer une température du bilame ou d'un autre élément du premier sous-système 55), il est diagnostiqué que la commutation est une commutation en raison du premier critère si et seulement si la valeur de deuxième température est supérieure ou égale au seuil de température auquel le premier sous-système 55 déclenche la commutation.

Il est à noter que, selon une variante qui ne fait pas partie de l'invention, les étapes 235 à 255 ne sont pas mises en oeuvre. Dans ce cas, le dispositif de diagnostic 20 est seulement configuré pour différencier un déclenchement en raison du deuxième critère d'un déclenchement manuel par l'organe 50.

## Revendications

1. Dispositif de diagnostic (20) destiné à un dispositif de commutation (10) comportant un module de commutation (15), le module de commutation (15) comportant une entrée (25), une sortie (30), un organe de commutation (35) et un système de déclenchement (40), l'organe de commutation (35) étant configuré pour commuter entre une première position dans laquelle l'organe de commutation (35) relie électriquement l'entrée (25) et la sortie (30) et une deuxième position dans laquelle l'organe de commutation (35) isole électriquement l'entrée (25) de la sortie (30), le système de déclenchement (40) étant propre à commander une commutation de l'organe de commutation (35) depuis la première position jusqu'à la deuxième position, le système de déclenchement (40) étant un système de déclenchement magnétothermique configuré pour commander la commutation lorsqu'un critère parmi un premier critère ou un deuxième critère est vérifié, le premier critère étant le fait qu'une première température d'un élément du système de déclenchement (40) est supérieure ou égale à un seuil de température, le deuxième critère étant le fait qu'un champ magnétique est supérieur ou égal à un seuil de champ, le champ magnétique étant généré par un courant électrique circulant entre l'entrée et la sortie lorsque l'organe de commutation (35) est dans la première position,
le dispositif de diagnostic (20) comportant un contrôleur (80) configuré pour détecter une commutation de l'organe de commutation (35) depuis la première position jusqu'à la deuxième position,
le dispositif de diagnostic (20) comportant un capteur de température (70) configuré pour estimer des valeurs d'une deuxième température du dispositif de commutation (10), et un capteur de courant (75) configuré pour mesurer des valeurs d'une intensité du courant, le dispositif de diagnostic (20) étant **caractérisé en ce que** le contrôleur (80) est configuré pour, suite à la détection d'une commutation,
diagnostiquer la commutation comme étant une commutation en raison du premier critère lorsqu'au moins une valeur d'intensité est supérieure ou égale à un dit troisième seuil de courant, le troisième seuil de courant étant fonction d'au moins une des valeurs de deuxième température estimée(s).

2. Dispositif de diagnostic selon la revendication 1, dans lequel le contrôleur (80) comporte une mémoire (100) et est configuré pour déterminer le troisième seuil de courant à partir d'une table, stockée en mémoire (100), et contenant des valeurs de troisième seuil de courant en fonction de la deuxième température, ou d'une fonction stockée en mémoire et reliant des valeurs de troisième seuil de courant à des valeurs de la deuxième température.

3. Dispositif de diagnostic selon l'une quelconque des revendications 1 ou 2, dans lequel le contrôleur (80) est configuré pour estimer au moins une valeur d'intensité à partir d'au moins une valeur d'une dérivée de l'intensité mesurée par le capteur de courant, et pour diagnostiquer la commutation comme étant une commutation en raison du premier critère en fonction de l'au moins une valeur d'intensité estimée.

4. Dispositif de diagnostic selon la revendication 3, dans lequel le contrôleur (80) est configuré pour :
- détecter une saturation du capteur de courant (75), estimer au moins une valeur d'intensité à partir d'au moins une valeur d'une dérivée de l'intensité mesurée et diagnostiquer la commutation en fonction au moins de la valeur d'intensité estimée lorsqu'une saturation est détectée, et pour
- diagnostiquer directement la commutation en fonction d'au moins une valeur d'intensité mesurée par le capteur (75) de courant en l'absence de saturation.

5. Dispositif de diagnostic selon la revendication 3 ou 4 dans lequel le courant est un courant alternatif présentant une période temporelle, chaque valeur d'intensité estimée étant estimée à partir d'une dérivée de l'intensité, la dérivée étant une dérivée maximale de l'intensité au cours d'une période temporelle du courant, chaque valeur d'intensité étant, notamment, estimée en considérant que l'intensité est une fonction sinusoïdale du temps.

6. Dispositif de diagnostic selon l'une quelconque des revendications 1 à 5, dans lequel au moins une valeur de deuxième température est une valeur moyenne de la deuxième température pendant une plage temporelle précédant la commutation.

7. Dispositif de diagnostic selon l'une quelconque des revendications 1 à 6, comportant, en outre, un capteur de courant (75) configuré pour mesurer des valeurs d'une intensité du courant, dans lequel le contrôleur (80) est, en outre, configuré pour comparer au moins une valeur d'intensité du courant à un deuxième seuil de courant et pour diagnostiquer une commutation en raison du deuxième critère lorsque la valeur d'intensité est supérieure ou égale au deuxième seuil de courant.

8. Dispositif de diagnostic selon la revendication 7, dans lequel le système de déclenchement (40) comporte un organe (50) configuré pour commander la commutation en fonction d'une commande d'un opérateur, le contrôleur (80) étant configuré pour diagnostiquer une commutation comme étant une commutation commandée par un opérateur si le contrôleur ne diagnostique pas la commutation comme étant une commutation en raison du premier critère ou du deuxième critère.

9. Dispositif de diagnostic selon l'une quelconque des revendications 1 à 8, dans lequel la deuxième température est une température du dispositif de diagnostic (20).

10. Dispositif de diagnostic selon l'une quelconque des revendications 1 à 8, dans lequel la deuxième température est une température du module de commutation (15).

11. Dispositif de commutation (10) comportant un module de commutation (15) comportant une entrée (25), une sortie (30), un organe de commutation (35) et un système de déclenchement (40), l'organe de commutation (35) étant configuré pour commuter entre une première position dans laquelle l'organe de commutation (35) relie électriquement l'entrée (25) et la sortie (30) et une deuxième position dans laquelle l'organe de commutation (35) isole électriquement l'entrée (25) de la sortie (30), le système de déclenchement (40) étant propre à commander une commutation de l'organe de commutation (35) depuis la première position jusqu'à la deuxième position, le système de déclenchement (40) étant un système de déclenchement magnétothermique configuré pour commander la commutation lorsqu'un critère parmi un premier critère ou un deuxième critère est vérifié, le premier critère étant le fait qu'une première température d'un élément du système de déclenchement (40) est supérieure ou égale à un seuil de température, le deuxième critère étant le fait qu'un champ magnétique est supérieur ou égal à un seuil de champ, le champ magnétique étant généré par un courant électrique circulant entre l'entrée et la sortie lorsque l'organe de commutation (35) est dans la première position, le dispositif de commutation (10) comportant un dispositif de diagnostic (20) selon l'une quelconque des revendications 1 à 10.

12. Dispositif de commutation selon la revendication 11, dans lequel le dispositif de diagnostic (20) comporte un premier boîtier (64) contenant le contrôleur (80), le module de commutation (15) comportant un deuxième boîtier (22) contenant l'organe de commutation (35) et le système de déclenchement (40), le premier boîtier (64) étant distinct du deuxième boîtier (22) et étant configuré pour être fixé au deuxième boîtier (22).

13. Dispositif de commutation selon la revendication 11, comportant un unique boîtier principal contenant le dispositif de diagnostic (20) et le module de commutation (15).

14. Procédé de diagnostic d'une commutation d'un dispositif de commutation (10) comportant un module de commutation (15) comportant une entrée (25), une sortie (30), un organe de commutation (35) et un système de déclenchement (40), l'organe de commutation (35) étant configuré pour commuter entre une première position dans laquelle l'organe de commutation (35) relie électriquement l'entrée (25) et la sortie (30) et une deuxième position dans laquelle l'organe de commutation (35) isole électriquement l'entrée (25) de la sortie (30), le système de déclenchement (40) étant propre à commander une commutation de l'organe de commutation (35) depuis la première position jusqu'à la deuxième position, le système de déclenchement (40) étant un système de déclenchement magnétothermique configuré pour commander la commutation lorsqu'un critère parmi un premier critère ou un deuxième critère est vérifié, le premier critère étant le fait qu'une première température d'un élément du système de déclenchement (40) est supérieure ou égale à un seuil de température, le deuxième critère étant le fait qu'un champ magnétique est supérieur ou égal à un seuil de champ, le champ magnétique étant généré par un courant électrique circulant entre l'entrée et la sortie lorsque l'organe de commutation (35) est dans la première position,
le procédé étant mis en oeuvre par un dispositif de diagnostic (20) comportant un contrôleur (80), un capteur de courant (75) et un capteur de température (70),
le procédé comportant des étapes de :
- mesure (200), par le capteur de température (70), d'au moins une valeur d'une deuxième température du dispositif de commutation,
- détection, par le contrôleur (80), d'une commutation de l'organe de commutation (35) depuis la première position jusqu'à la deuxième position, et
- diagnostic (255), par le contrôleur (80), de la commutation comme étant une commutation en raison du premier critère lorsqu'au moins une valeur d'intensité est supérieure ou égale à un dit troisième seuil de courant, le troisième seuil de courant étant fonction d'au moins une des valeurs de deuxième température estimée(s).

## Patentansprüche

1. Diagnosevorrichtung (20), die für eine Schaltvorrichtung (10) bestimmt ist, umfassend ein Schaltmodul (15), das Schaltmodul (15) umfassend einen Eingang (25), einen Ausgang (30), ein Schaltglied (35) und ein Auslösesystem (40), wobei das Schaltglied (35) konfiguriert ist, um zwischen einer ersten Position, in der das Schaltglied (35) den Eingang (25) und den Ausgang (30) elektrisch verbindet, und einer zweiten Position, in der das Schaltglied (35) den Eingang (25) elektrisch von dem Ausgang (30) isoliert, zu schalten, wobei das Auslösesystem (40) dazu geeignet ist, um ein Schalten des Schaltglieds (35) von der ersten Position in die zweite Position zu steuern, das Auslösesystem (40) ein magnetothermisches Auslösesystem ist, das konfiguriert ist, um die Schaltung zu steuern, wenn ein Kriterium von einem ersten Kriterium oder einem zweiten Kriterium verifiziert wird, wobei das erste Kriterium die Tatsache ist, dass eine erste Temperatur eines Elements des Auslösesystems (40) größer als oder gleich wie ein Temperaturschwellenwert ist, das zweite Kriterium die Tatsache ist, dass ein Magnetfeld größer als oder gleich wie ein Feldschwellenwert ist, wobei das Magnetfeld durch einen elektrischen Strom erzeugt wird, der zwischen dem Eingang und dem Ausgang fließt, wenn das Schaltglied (35) in der ersten Position ist,
die Diagnosevorrichtung (20) umfassend eine Steuereinheit (80), die konfiguriert ist, um ein Schalten des Schaltglieds (35) von der ersten Position in die zweite Position zu erfassen,
die Diagnosevorrichtung (20) umfassend
einen Temperatursensor (70), der konfiguriert ist, um Werte einer zweiten Temperatur der Schaltvorrichtung (10) zu schätzen, und einen Stromsensor (75), der konfiguriert ist, um Werte einer Stromstärke des Stroms zu messen, wobei die Diagnosevorrichtung (20) **dadurch gekennzeichnet ist, dass** die Steuerung (80)
konfiguriert ist, um nach der Erfassung einer Schaltung
das Schalten als ein Schalten aufgrund des ersten Kriteriums zu diagnostizieren, wenn mindestens ein Stromstärkewert größer als oder gleich wie ein sogenannter dritter Stromschwellenwert ist, wobei der dritte Stromschwellenwert von mindestens einem der geschätzten zweiten Temperaturwerte abhängt.

2. Diagnosevorrichtung nach Anspruch 1, wobei die Steuereinheit (80) einen Speicher (100) umfasst und konfiguriert ist, um den dritten Stromschwellenwert anhand einer Tabelle, die in dem Speicher (100) gespeichert ist und Werte des dritten Stromschwellenwerts abhängig von der zweiten Temperatur enthält, oder anhand einer Funktion, die in dem Speicher gespeichert ist und Werte des dritten Stromschwellenwerts mit Werten der zweiten Temperatur verbindet, zu bestimmen.

3. Diagnosevorrichtung nach einem der Ansprüche 1 oder 2, wobei die Steuerung (80) konfiguriert ist, um mindestens einen Stromstärkewert anhand mindestens eines Werts einer Ableitung der von dem Stromsensor gemessenen Stromstärke zu schätzen und um die Schaltung als eine Schaltung aufgrund des ersten Kriteriums basierend auf dem mindestens einen geschätzten Stromstärkewert zu diagnostizieren.

4. Diagnosevorrichtung nach Anspruch 3, wobei die Steuerung (80) zu Folgendem konfiguriert ist:
- Erfassen einer Sättigung des Stromsensors (75), Schätzen mindestens eines Stromstärkewerts anhand mindestens eines Wert einer Ableitung der gemessenen Stromstärke und Diagnostizieren der Schaltung basierend mindestens auf dem geschätzten Stromstärkewert, wenn eine Sättigung erfasst wird, und um
- direkt die Schaltung abhängig von mindestens einem von dem Stromsensor (75) gemessenen Stromstärkewert bei nicht vorliegender Sättigung zu diagnostizieren.

5. Diagnosevorrichtung nach Anspruch 3 oder 4, bei der der Strom ein Wechselstrom ist, der eine Zeitperiode aufweist, wobei jeder geschätzte Stromstärkewert anhand einer Ableitung der Stromstärke geschätzt wird, wobei die Ableitung eine maximale Ableitung der Stromstärke während einer Zeitperiode des Stroms ist, wobei jeder Stromstärkewert insbesondere unter der Annahme geschätzt wird, dass die Stromstärke eine sinusförmige Funktion der Zeit ist.

6. Diagnosevorrichtung nach einem der Ansprüche 1 bis 5, wobei mindestens ein Wert der zweiten Temperatur ein Durchschnittswert der zweiten Temperatur während eines Zeitbereichs vor dem Schalten ist.

7. Diagnosevorrichtung nach einem der Ansprüche 1 bis 6, ferner umfassend einen Stromsensor (75), der konfiguriert ist, um Werte einer Stromstärke des Stroms zu messen, wobei die Steuerung (80) ferner konfiguriert ist, um mindestens einen Stromstärkewert des Stroms mit einem zweiten Stromschwellenwert zu vergleichen und ein Schalten aufgrund des zweiten Kriteriums zu diagnostizieren, wenn der Stromstärkewert größer als oder gleich wie der zweite Stromschwellenwert ist.

8. Diagnosevorrichtung nach Anspruch 7, wobei das Auslösesystem (40) ein Glied (50) umfasst, das konfiguriert ist, um die Umschaltung abhängig von einem Befehl eines Bedieners zu steuern, wobei die Steuerung (80) konfiguriert ist, um eine Schaltung als eine von einem Bediener gesteuerte Schaltung zu diagnostizieren, wenn die Steuerung die Schaltung nicht als eine Schaltung aufgrund des ersten Kriteriums oder des zweiten Kriteriums diagnostiziert.

9. Diagnosevorrichtung nach einem der Ansprüche 1 bis 8, wobei die zweite Temperatur eine Temperatur der Diagnosevorrichtung (20) ist.

10. Diagnosevorrichtung nach einem der Ansprüche 1 bis 8, wobei die zweite Temperatur eine Temperatur des Schaltmoduls (15) ist.

11. Schaltvorrichtung (10), umfassend Schaltmodul (15), umfassend einen Eingang (25), einen Ausgang (30), ein Schaltglied (35) und ein Auslösesystem (40), wobei das Schaltglied (35) konfiguriert ist, um zwischen einer ersten Position, in der das Schaltglied (35) den Eingang (25) und den Ausgang (30) elektrisch verbindet, und einer zweiten Position, in der das Schaltglied (35) den Eingang (25) elektrisch von dem Ausgang (30) isoliert, zu schalten, wobei das Auslösesystem (40) dazu geeignet ist, um ein Schalten des Schaltglieds (35) von der ersten Position in die zweite Position zu steuern, das Auslösesystem (40) ein magnetothermisches Auslösesystem ist, das konfiguriert ist, um die Schaltung zu steuern, wenn ein Kriterium von einem ersten Kriterium oder einem zweiten Kriterium verifiziert wird, wobei das erste Kriterium die Tatsache ist, dass eine erste Temperatur eines Elements des Auslösesystems (40) größer als oder gleich wie ein Temperaturschwellenwert ist, das zweite Kriterium die Tatsache ist, dass ein Magnetfeld größer als oder gleich wie ein Feldschwellenwert ist, wobei das Magnetfeld durch einen elektrischen Strom erzeugt wird, der zwischen dem Eingang und dem Ausgang fließt, wenn das Schaltglied (35) in der ersten Position ist, die Schaltvorrichtung (10) umfassend eine Diagnosevorrichtung (20) nach einem der Ansprüche 1 bis 10.

12. Schaltvorrichtung nach Anspruch 11, wobei die Diagnosevorrichtung (20) ein erstes Gehäuse (64) umfasst, das die Steuerung (80) enthält, das Schaltmodul (15) umfassend ein zweites Gehäuse (22), das das Schaltglied (35) und das Auslösesystem (40) enthält, wobei das erste Gehäuse (64) von dem zweiten Gehäuse (22) getrennt ist und konfiguriert ist, um an dem zweiten Gehäuse (22) befestigt zu werden.

13. Schaltvorrichtung nach Anspruch 11, umfassend ein einziges Hauptgehäuse, das die Diagnosevorrichtung (20) und das Schaltmodul (15) enthält.

14. Diagnoseverfahren einer Schaltung einer Schaltvorrichtung (10), umfassend ein Schaltmodul (15), umfassend einen Eingang (25), einen Ausgang (30), ein Schaltglied (35) und ein Auslösesystem (40), wobei das Schaltglied (35) konfiguriert ist, um zwischen einer ersten Position, in der das Schaltglied (35) den Eingang (25) und den Ausgang (30) elektrisch verbindet, und einer zweiten Position, in der das Schaltglied (35) den Eingang (25) elektrisch von dem Ausgang (30) isoliert, zu schalten, wobei das Auslösesystem (40) dazu geeignet ist, um ein Schalten des Schaltglieds (35) von der ersten Position in die zweite Position zu steuern, das Auslösesystem (40) ein magnetothermisches Auslösesystem ist, das konfiguriert ist, um die Schaltung zu steuern, wenn ein Kriterium von einem ersten Kriterium oder einem zweiten Kriterium verifiziert wird, wobei das erste Kriterium die Tatsache ist, dass eine erste Temperatur eines Elements des Auslösesystems (40) größer als oder gleich wie ein Temperaturschwellenwert ist, das zweite Kriterium die Tatsache ist, dass ein Magnetfeld größer als oder gleich wie ein Feldschwellenwert ist, wobei das Magnetfeld durch einen elektrischen Strom erzeugt wird, der zwischen dem Eingang und dem Ausgang fließt, wenn das Schaltglied (35) in der ersten Position ist,
wobei das Verfahren durch eine Diagnosevorrichtung (20) implementiert wird, umfassend eine Steuerung (80), einen Stromsensor (75) und einen Temperatursensor (70),
das Verfahren umfassend die folgenden Schritte:
- Messen (200), durch den Temperatursensor (70), von mindestens einem Wert einer zweiten Temperatur der Schaltvorrichtung,
- Erfassen, durch die Steuereinheit (80), eines Schaltens des Schaltelements (35) von der ersten Position in die zweite Position, und
- Diagnostizieren (255), durch die Steuereinheit (80), der Schaltung als eine Schaltung aufgrund des ersten Kriteriums, wenn mindestens ein Stromstärkewert größer als oder gleich wie ein so genannter dritter Stromschwellenwert ist, wobei der dritte Stromschwellenwert von mindestens einem der geschätzten zweiten Temperaturwerte abhängt.

## Claims

1. A diagnostic device (20) for a switching device (10) having a switching module (15), the switching module (15) having an input (25), an output (30), a switching member (35) and a trigger system (40), **characterised in that** the switching member (35) being configured to switch between a first position in which the switching member (35) electrically connects the input (25) and the output (30) and a second position in which the switching member (35) electrically isolates the input (25) from the output (30), the trigger system (40) being suitable for controlling switching of the switching member (35) from the first position to the second position, the trigger system (40) being a magneto-thermal trigger system configured to control switching when one of a first criterion or a second criterion is verified, the first criterion being the fact that a first temperature of an element of the trigger system (40) is greater than or equal to a temperature threshold, the second criterion being the fact that a magnetic field is greater than or equal to a field threshold, the magnetic field being generated by an electric current flowing between the input and the output when the switching member (35) is in the first position,
the diagnostic device (20) comprising a controller (80) configured to detect switching of the switching member (35) from the first position to the second position,
the diagnostic device (20) comprising
a temperature sensor (70) configured to estimate values of a second temperature of the switching device (10), and a current sensor (75) configured to measure values of a current intensity of the current, the diagnostic device (20) being **characterised in that** the
controller (80) is configured to, following the detection of a switch,
diagnose the switching as being a switching due to the first criterion when at least one current value is greater than or equal to a said third current threshold, the third current threshold being a function of at least one of the estimated second temperature value(s).

2. A diagnostic device according to claim 1, wherein the controller (80) comprises a memory (100) and is configured to determine the third current threshold from a table, stored in the memory (100), containing third current threshold values as a function of the second temperature, or from a function stored in the memory and relating third current threshold values to values of the second temperature.

3. A diagnostic device according to any one of claims 1 or 2, wherein the controller (80) is configured to estimate at least one current value from at least one value of a derivative of the current measured by the current sensor, and to diagnose the switching as switching due to the first criterion as a function of the at least one estimated current value.

4. A diagnostic device of claim 3, wherein the controller (80) is configured to:
- detect saturation of the current sensor (75), estimating at least one current value from at least one value of a derivative of the measured current and diagnose the switching as a function of at least the estimated current value when saturation is detected, and to
- diagnose switching directly as a function of at least one current value measured by the current sensor (75) in the absence of saturation.

5. A diagnostic device according to claim 3 or 4 in which the current is an alternating current having a time period, each estimated current value being estimated from a derivative of the current, the derivative being a maximum derivative of the current over a time period of the current, each current value being, in particular, estimated by considering that the current is a sinusoidal function of time.

6. A diagnostic device according to any one of claims 1 to 5, wherein at least one second temperature value is an average value of the second temperature over a time range prior to switching.

7. A diagnostic device according to any one of claims 1 to 6, further comprising a current sensor (75) configured to measure values of a current magnitude, wherein the controller (80) is further configured to compare at least one current value of the current to a second current threshold and to diagnose switching due to the second criterion when the current value is greater than or equal to the second current threshold.

8. A diagnostic device according to claim 7, wherein the triggering system (40) comprises a member (50) configured to control switching in accordance with an operator command, the controller (80) being configured to diagnose a switch as being an operator-controlled switch if the controller does not diagnose the switch as being a switch due to the first criterion or the second criterion.

9. A diagnostic device according to any one of claims 1 to 8, wherein the second temperature is a temperature of the diagnostic device (20).

10. A diagnostic device according to any one of claims 1 to 8, wherein the second temperature is a temperature of the switch module (15).

11. A switching device (10) comprising a switching module (15) comprising an input (25), an output (30), a switching member (35) and a tripping system (40), the switching member (35) being configured to switch between a first position in which the switching member (35) electrically connects the input (25) and the output (30) and a second position in which the switching member (35) electrically isolates the input (25) from the output (30), the triggering system (40) being suitable for controlling a switching of the switching member (35) from the first position to the second position, the triggering system (40) being a magneto-thermal triggering system configured to control the switching when one of a first criterion or a second criterion is verified, the first criterion being the fact that a first temperature of an element of the triggering system (40) is greater than or equal to a temperature threshold, the second criterion being the fact that a magnetic field is greater than or equal to a field threshold, the magnetic field being generated by an electric current flowing between the input and the output when the switching member (35) is in the first position, the switching device (10) comprising a diagnostic device (20) according to any one of claims 1 to 10.

12. A switching device according to claim 11, wherein the diagnostic device (20) comprises a first housing (64) containing the controller (80), the switching module (15) comprising a second housing (22) containing the switching member (35) and the triggering system (40), the first housing (64) being separate from the second housing (22) and being configured to be secured to the second housing (22).

13. A switching device as claimed in claim 11, comprising a single main housing containing the diagnostic device (20) and the switching module (15).

14. A method of diagnosing switching in a switching device (10) comprising a switching module (15) having an input (25), an output (30), a switching member (35) and a trigger system (40), **characterised in that** the switching member (35) being configured to switch between a first position in which the switching member (35) electrically connects the input (25) and the output (30) and a second position in which the switching member (35) electrically isolates the input (25) from the output (30), the trigger system (40) being suitable for controlling switching of the switching member (35) from the first position to the second position, the tripping system (40) being a magneto-thermal tripping system configured to control switching when one of a first criterion or a second criterion is verified, the first criterion being the fact that a first temperature of an element of the tripping system (40) is greater than or equal to a temperature threshold, the second criterion being the fact that a magnetic field is greater than or equal to a field threshold, the magnetic field being generated by an electric current flowing between the input and the output when the switching member (35) is in the first position,
the method being implemented by a diagnostic device (20) comprising a controller (80), a current sensor (75) and a temperature sensor (70),
the method comprising the steps of:
- measurement (200), by the temperature sensor (70), of at least one value of a second temperature of the switching device,
- detection, by the controller (80), of switching of the switching member (35) from the first position to the second position, and
- diagnosis (255), by the controller (80), of the switching as being a switching due to the first criterion when at least one current value is greater than or equal to a said third current threshold, the third current threshold being a function of at least one of the estimated second temperature value(s).
